# EUROPEAN PATENT APPLICATION

(11) **EP 1 233 370 A1**
(43) Date of publication of application: **21.08.2002**
(21) Application number: 01301920.3
(22) Date of filing: 02.03.2001
(51) Int. Cl.: G06K 19/067, H01F 41/04

(54) **Method of manufacturing resonant circuits**

(30) Priority: 06.02.2001 US 777132
(71) Applicant: WESTVACO CORPORATION, New York New York 10171 (US)
(72) Inventor: Rasband, Paul Brent, Frederick, Maryland 21701 (US)
(74) Representative: Thomson, Paul Anthony

(57) **Abstract**

A method of making a resonant circuit having, as one element thereof, an inductor comprising a series of discrete segments of a conductive metal material connected by conductive ink printed between the segments.

## Description

### Field of Industrial Applicability

The present invention relates to a method of making a continuous loop resonant circuit device for use in a variety of applications in which a low-cost circuit element of relatively high conductivity is desired. The invention is useful in the manufacture of resonant circuits and other contactless identification devices.

### BACKGROUND OF THE INVENTION

In recent times, automatic identification technology has become increasingly popular, and has found application in many areas, such as security and loss prevention, as well as in promoting rapid transactions involving money or confidential information. Contactless identification, which is a newer development in automatic identification technology, is commonly used in applications that provide an efficient and accurate means of quickly communicating information. Such a system provides for the transfer of power and data between a data-carrying device and a reader without contact between the device and the reader. The contactless identification system, which is also known as radio frequency identification (RFID), functions via the interaction between two components: an inductor or antenna and a reader or interrogator. The inductor is located on the object to be identified and tuned to the frequency of the reader, and the reader is equipped with a radio frequency transmitter /receiver and a contactless coupling unit, which is coupled to the inductor when it is within the interrogation range of the reader. Within this range, the coupling unit supplies power to the inductor to activate it and allow transmission of data.

This RFID mechanism has proven to be useful in a range of technology applications. Examples of these include resonant circuits, which may be exemplified by a particular application in the form of security tags (1-bit RFID) for electronic article surveillance (EAS) articles. Such articles containing RF-EAS (Radio Frequency Electronic Article Surveillance) circuits are often comprised of a single inductor and capacitor in a loop, forming an inductance/capacitor (LC) resonant circuit. RPID circuits typically include at least one capacitor, for example, on a computer chip (IC) and additionally include an external inductor coil to provide inductance for the resonant circuit and serve as an antenna. The production of LC circuits with sharp, frequency-specific resonance requires that the L/C ratio, where L is the measure of resistance to changes in current, and C is a measure of the circuit's ability to store electrical energy in the form of a segregated charge, be as great as possible. These criteria generally require an inductor with a large number of loops. Also, the total surface area to be occupied by the circuit is usually required to be as small as possible so that the EAS or RFID tag is not noticeable or obtrusive. These two requirements encourage the use of inductors with thin, tightly spaced loops. Another requirement for sharp resonance is that the inductor's resistance be kept as low as possible. This requirement is best met by using solid metal foils rather than printed or hot-stamped materials. Moreover, die stamping of inductors containing many thin loops is a difficult and tricky process.

Presently, there are two basic types of RF-EAS security tags that are commercially available. One type is a reusable tag that can be fastened to the products to be protected, while the other is a disposable type, which can be adhered to the packaging in which the products are packaged, or prepared as a part of the packaging material itself. These tags utilize technology based on tuned circuits that operate in the radio frequency range. An example of the disposable type of security tag is disclosed in U.S. Patent No. 6,177,871.

Disposable EAS and RFID tags often are manufactured by affixing discrete inductor and capacitor elements to a dielectric substrate. Such elements may be formed by conventional fabrication methods for forming printed circuits, including selected use of laminated substrates having an interior dielectric layer laminated on both surfaces with a conductive composition such as copper. The conductive layers may be printed with an etchant resistant material in the form of the desired circuit, and, after etching, the remaining conductive material forms the circuit. Alternatively, the resonant tag circuits can be formed by stamping, embossing or die cutting the circuits out of thin metal sheets, which are then adhered or laminated to the dielectric substrate.

Efforts to print inductor loops are disclosed, for example, in U.S. Patent Nos. 5,442,334 and 5,781,110. However, conductive inks generally have a resistivity that is one to two orders of magnitude greater than solid metals such as aluminum. Likewise, the fabrication of inductor elements using die-stamping techniques, or, alternatively, die-cutting and subsequent transfer, especially of an inductor foil containing many thin loops, is a difficult and exacting process, since the fracture of the loop at any point results in an open circuit and an ineffective conductor. There remains a need in the art, therefore, for an efficient method of forming an inductor element that can be used in a resonant circuit device, or, indeed, any type of device in which contactless identification is desired, in which the occurrence of these and other previously described defects recognized in the art is diminished.

### SUMMARY OF THE INVENTION

The present invention addresses the deficiencies of the prior art by providing a means of manufacturing a composite foil/ink inductor element, which, surprisingly, and successfully, incorporates advantages of the die-stamping and conductive ink printing processes that have previously been used for resonant circuit manufacture.

The present invention entails, in one aspect, a method of manufacturing a resonant circuit device comprising:
a) applying a series of discrete metal inductor loop segments consisting of a stampable, conductive metal in a pattern on the surface of a self-supporting substrate, the pattern having interstitial areas between the segments;
b) removing excess metal from the interstitial areas;
c) printing conductive ink segments in the interstitial areas to form a continuous inductor element; and
d) connecting the inductor element to a capacitor or RFID computer chip with concentrated or distributed capacitance to form a resonant circuit.

In another embodiment, the invention comprises a method for forming an inductor element comprising:
a) applying a series of discrete metal inductor loop segments consisting of a stampable, conductive metal in a pattern on the surface of a self-supporting substrate, the pattern having one or more interstitial areas between the metal segments;
b) removing excess metal from the interstitial areas; and
c) printing segments of a conductive ink in the interstitial areas to form a continuous inductor element.

The invention additionally comprises an inductor element for RFID applications, comprising a series of discrete metal segments affixed to an insulating substrate, and further comprising printed segments of conductive ink in the interstitial spaces between the metal foil segments.

### BRIEF DESCRIPTION OF THE DRAWINGS

Figure 1 is a planar view of the first step in making a coiled inductor element according to the invention, illustrating the discrete metal segments of the inductor loop.
Figure 2 is a plan view showing a printing pattern for the conductive ink segments to be applied between the metal segments.
Figure 3 is a plan view of a completed, continuous inductor loop element comprising metal segments and conductive ink segments according to the invention.
Figure 4 is a schematic diagram showing a continuous process for manufacturing inductor elements according to one embodiment of the invention.

### DETAILED DESCRIPTION OF THE PREFERRED EMBODIMENTS

In accordance with the present invention, an RFID-type resonant circuit device may be formed on a self-supporting substrate. By "self-supporting," it is meant that the substrate can be processed to form the resonant circuit or other inductive type circuits without the use of a backing or support layer. The use of a self-supporting layer that can be processed and handled without the use of a structural support layer allows for efficient separation of the circuits from the excess manufacturing material without failure of the substrate due to tearing or breaking during the manufacturing process. The self-supporting substrate should preferably be an insulating dielectric material, having a conductivity lower than that of the circuit to be formed thereon. In this regard, suitable substrates may be selected from polymer films, paperboard, paper, or any other insulating substrate or combination thereof. Examples of such materials include, but are not limited to, uncoated or polymer-coated paper or paperboard, self-supporting polyester, polyethylene naphthenate (PEN), polyvinyl chloride (PVC), polyamide, other polymer films, fabric and glass.

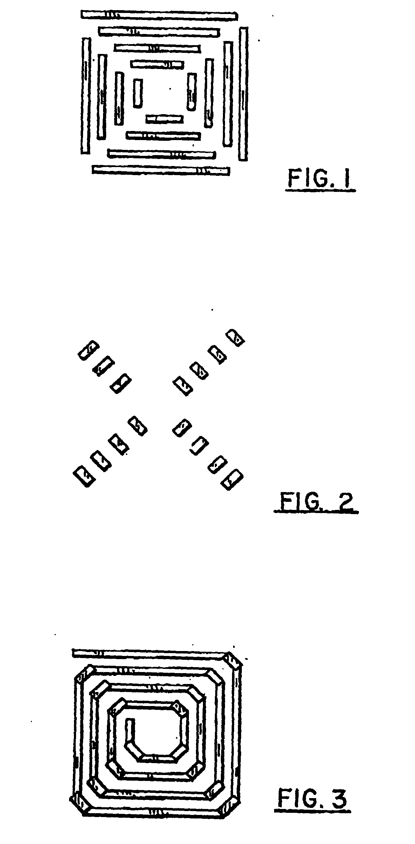

According to the process of the invention, a conductive metal material, such as a metal foil, is laid down and affixed, in segments, on the surface of the substrate. The conductive metal is preferably aluminum, copper or any other conductive, malleable metal. The segments may be placed simultaneously or sequentially by any suitable method known in the art. Typically, the metal segments are deposited on the substrate by die embossing using a knife-edged die or embossing die, or by die stamping or hot stamping; however, any other means that is known in the art may also be used. The pattern for stamping is typically such that unstamped gaps will be interspersed between the segments. The thickness of the metal foil stock that can be used is limited only by the ability of the substrate to remain self-supporting after the inductor segments have been applied. The segments of metal foil may be linear or nonlinear, and may be applied in a linear, curved, looped or arced configuration, depending on the functional and aesthetic design requirements of the circuit being constructed. Figures 1-3 demonstrate the preparation of a coiled, continuous loop inductor element, which is but one preferred embodiment of the present invention.

When the method of applying the conductive metal is stamping or embossing, there is typically an excess of conductive metal material left on the surface of the substrate that must be removed to expose the metal inductor segments. This may be achieved by peeling away the excess metal foil between and around the segments, thereby leaving a series of metal inductor segments separated by interstitial spaces or gaps of the desired length and width. The unstamped interstitial areas support the excess foil to facilitate its removal. The degree of separation between the metal segments, as determined by the width of the gap, may be varied depending on the reinforcement requirements of the excess foil.

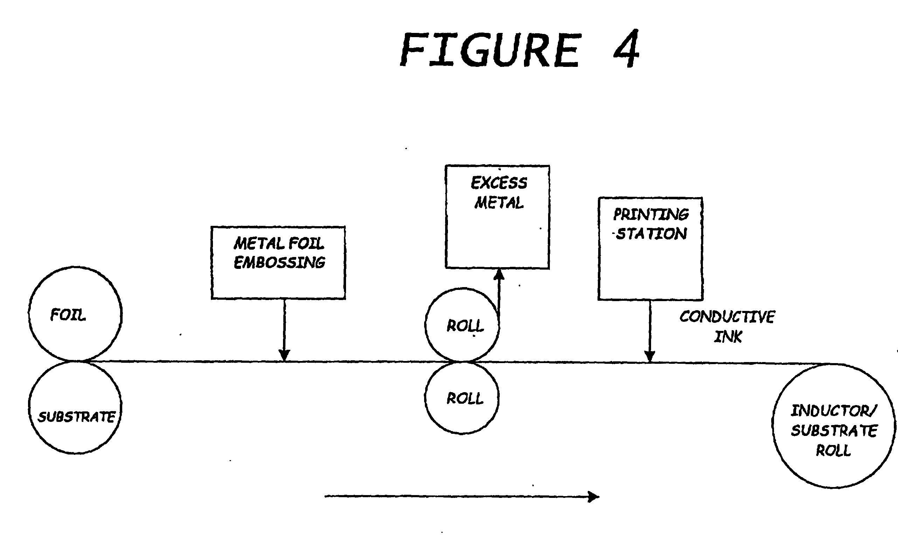

Where the metal inductor segments are applied continuously on a rolled substrate in a roll-to-roll manufacturing scheme, the excess metal foil can be peeled away from the metal inductor segments by passing the substrate through a nip formed by a pair of finishing rolls. The substrate with the metal foil segments is then moved through a printing station where the conductive ink is applied. Any conventional printing process, such as screen-printing may be used. After the conductive ink has been. printed and dried, the substrate having the completed inductor elements affixed thereto may be wound onto a take-up roll for storage or subsequent processing. Such a process is described in the schematic diagram of Figure 4. Alternatively, in a batch or sheet-fed process, the excess material may be manually or mechanically peeled away from individual sheets that have been stamped or embossed with the conductive metal material.

According to the invention, after the excess metal has been separated from the metal inductor segments, a conductive ink is then printed in the interstitial areas between the metal segments to bridge the gaps and form a continuous inductor. The layout of the metal and conductive ink segments is preferably in the form of a coil or loop, particularly if the circuit will be used in desirably unobtrusive applications, such as electronic article surveillance. However, the dimensions and layout or other arrangement of the inductor are not intended to be limited in any way, as these may be varied according to the intended end use. The term "conductive ink," as used herein, includes any suitable electrically conductive ink, paste or fluid, examples of which may be selected from polymer conductive inks, silver metallic paste, graphite-based inks and other conductive printing inks. After printing, the ink segments may then be air-dried or dried and set by exposure to heat, UV radiation, or electron beam.

To complete the resonant circuit, the inductor is linked to a capacitor, which accumulates and segregate the electrical charge introduced into the circuit. Single or series capacitors, which may be laminated metal-polymer-metal, air capacitors, mica capacitors or paper capacitors may be used. Printing of capacitor plates and capacitor dielectrics is also possible.

The inductor element of the present invention may also be used as a magnetic dipole antenna, which may be incorporated into a number of product applications. Examples of these include tank circuits for radio receivers, EAS tags and other devices, radio amplifiers, narrow bandwidth tuners and oscillators.

Depending on the intended application, the completed resonant circuit comprising metal and conductive ink segments may be subjected to further processing, such as lamination, in which one or more additional layers may be sealed or affixed atop or beneath the substrate bearing the circuit. For example, the circuit may be placed between layers of a paperbcard material to form a security tag, or it may be laminated with other materials, such as plastic or polymer-coated paperboard, to form articles such as portable cards. The inductor circuits formed according to the invention may be used in a wide variety of applications in the field of RFID technology. For example, the circuits may form resonant circuit devices capable of receiving or transmitting radio frequency signals in transponder units, such as those used in "smart-cards" (e.g. phone cards, banking cards, security clearance cards and the like). Alternatively, the circuits may be employed as LC circuits in EAS security tags used in a range of retail inventory security applications.

### EXAMPLES

An inductor element was produced using a die-stamping process. Segments of aluminum foil, 0.0381 mm (1.5 mil) thickness, "0" temper (Arclad S-6587, from Adhesive Research Inc.), were die-stamped in a coil arrangement onto a coated bleached paperboard substrate. Segments of 112-S silver metallic conductive paste (Electroscience Laboratories, Inc.) were then screen printed in the gaps between the metal segments, thereby connecting the segments to form an inductor. After connecting the inductor so formed to a variable air capacitor and adjusting C in the resulting circuit, a resonance frequency of 8.0 MHz was obtained, as measured by a hand-held dip meter. The C value required for this resonance frequency was 0.13 nF (as measured by a hand-held multimeter).

The resistance around the inductor (total 6 loops) was 1.4 ohms. This result compares favorably to an inductor of the same size and shape, made with foil only, which was determined to have a resistance of 0.6 ohms. If the identical inductor were printed using the aforementioned silver metallic paste, the resistance would be approximately 20 ohms, producing a Q-factor, which is a measure of resonance sharpness or bandwidth, of about 10-15 times less than the Q-factor for the present invention. Accordingly, it may be seen that the composite foil/ink inductor of the present invention provides a suitable and highly reliable substitute for an all-foil inductor or a printed inductor.

It is believed that the present invention includes many other embodiments that may not be herein described in detail, but would nonetheless be appreciated by those skilled in the art from the disclosures made. Accordingly, this disclosure should not be read as being limited only to the foregoing examples or only to the designated preferred embodiments.

## Claims

1. A method for manufacturing a resonant circuit device comprising:
a) applying a series of discrete metal inductor loop segments consisting of a stampable, conductive metal in a pattern on the surface of a self-supporting substrate, the pattern having interstitial areas between the segments;
b) removing excess metal from the interstitial areas;
c) printing conductive ink segments in the interstitial areas to form a continuous inductor element; and
d) connecting the inductor element to a capacitor or RFID computer chip with concentrated or distributed capacitance to form a resonant circuit.

2. The method of claim 1, wherein the conductive metal. is affixed to the surface of the substrate by die stamping, hot-stamping, knife-embossing or die-embossing.

3. The method of claim 1, wherein the conductive metal is aluminum or copper.

4. The method of claim 3, wherein the metal is in the form of a foil.

5. The method of claim 1, wherein the self-supporting substrate is an insulating dielectric material.

6. The method of claim 5, wherein the insulating dielectric material is selected from the group consisting of uncoated or polymer-coated paper or paperboard, polyester, polyethylene naphthenate, polyvinyl chloride, polyamide, polymer films, fabric, glass, and combinations thereof.

7. The method of claim 1, wherein the printing method is screen-printing.

8. The method of claim 1, wherein the conductive ink is selected from the group consisting of polymer thick film conductive ink, silver metallic paste, and graphite based ink.

9. A resonant circuit produced according to the method of claim 1.

10. A method for forming an inductor element comprising:
a) applying a series of discrete metal inductor loop segments consisting of a conductive metal in a pattern on the surface of a dielectric substrate, the pattern having one or more interstitial areas between the metal segments;
b) removing excess metal from the interstitial areas; and
c) printing segments of a conductive ink in the interstitial areas to form a continuous inductor element.

11. The method of claim 10, wherein the metal inductor loop segments are applied in a pattern to form a coil.

12. The method of claim 11, wherein the metal is copper or aluminum foil.

13. The method of claim 10, wherein the excess metal is removed from the interstitial areas by passing the substrate through a nip to separate the excess metal from the substrate.

14. The method of claim 10, wherein the self-supporting substrate is an insulating dielectric material.

15. The method of claim 14, wherein the insulating dielectric material is selected from the group consisting of uncoated or polymer-coated paper or paperboard, polyester, polyethylene naphthenate, polyvinyl chloride, polyamide, polymer films, fabric and glass.

16. The method of claim 10, wherein the printing method is screen-printing.

17. An inductor element formed by the process of claim 10.

18. An inductor element for RFID applications, comprising a series of discrete metal segments affixed to an insulating, dielectric substrate, and further comprising printed segments of conductive ink in the interstitial spaces between the metal foil segments.
